# EUROPEAN PATENT SPECIFICATION

(11) **EP 3 399 545 B1**
(45) Date of publication and mention of the grant of the patent: **29.09.2021**
(21) Application number: 17169429.2
(22) Date of filing: 04.05.2017
(51) Int. Cl.: H01L 21/683, H01J 37/32

(54) **SUBSTRATE TREATMENT SYSTEM**
SUBSTRATBEHANDLUNGSSYSTEM
SYSTÈME DE TRAITEMENT DE SUBSTRAT

(43) Date of publication of application: 07.11.2018
(73) Proprietor: Meyer Burger (Germany) GmbH, 09337 Hohenstein-Ernstthal (DE)
(72) Inventor: Strahm, Benjamin, 1429 Giez (CH); Legradic, Boris, 1400 Yverdon-les-Bains (CH)
(74) Representative: Steiniger, Carmen

(56) References cited:
- WO-A1-98/43291
- WO-A2-2005/024891
- GB-A- 2 261 396
- JP-A- S59 205 719
- US-A1- 2011 245 957

## Description

The present invention relates to a substrate treatment system with at least one substrate carrier carrying at least one plate-like substrate and comprising at least one dielectric region, wherein a front side of the dielectric region is opposite to a back side of the substrate, and with an electrically conductive electrode provided on the back side of the substrate carrier or being formed by the substrate carrier.

Existing technologies suffer from non-uniformities of the deposited material due to standing wave and telegraph effect, inhomogeneous gas flow etc. A change of plasma parameters, especially of the RF-frequency, often implies a complete redesign of the reactor.

The document EP 1 208 583 B1 suggests a parallel plate plasma reactor with a reduced electromagnetic inhomogeneity for the treatment of one substrate inside a process chamber. The plasma reactor comprises a first electrode being connected with an RF source and a second electrode being grounded. The substrate lies on the second electrode during its plasma treatment. The second electrode comprises an extra-capacity in form of a concave dielectric layer being in series with the substrate and the plasma and forming therewith a capacitive voltage divider. In particular, the thickness of said concave dielectric layer has its maximum at the center of the substrate. The known technology is only suited for one substrate and has, therefore, a low efficiency. Moreover, manufacturing the suggested electrode with the lens-formed dielectric is very complicated. Furthermore, each of such electrodes is only suited for one special application, leading to the effect that a new electrode has to be provided for each new process.

The document JP S59 205719 A suggests a parallel plate reactor with an anode and a cathode. On the cathode, an insulator is formed. On the insulator, a wafer is placed during a dry-etch process. The cathode has a convex part and the thickness of the insulator at the centre of the wafer is thinner than at the circumference of the wafer. With this constellation, the etching rate at the centre of the wafer shall be improved.

The document US 2011/0245957 A1 discloses a substrate processing system with several substrate carriers on which several substrates can be placed and which can be moved to transport the substrates into and out of a processing chamber, such as a PECVD chamber.

It is therefore the object of the present invention to suggest a flexible substrate treatment system to improve the homogeneity of a plasma process for one large substrate or multiple substrates provided at the same time on a substrate carrier.

The object is solved by a substrate treatment system with at least one substrate carrier carrying at least one plate-like substrate, comprising at least one dielectric region, wherein a front side of the dielectric region is opposite to a back side of the substrate, and with an electrically conductive electrode provided on the back side of the substrate carrier, wherein a distance between the back side of the substrate and a back side of the dielectric region varies over the width of the dielectric region and/or varies from one of the dielectric regions to another of the dielectric regions, and/or the electrode comprises at least one additional dielectric region being allocated to the at least one dielectric region, and a distance between the back side of the substrate and a back side of the additional dielectric region varies over the width of the additional dielectric region and/or varies from one of the additional dielectric regions to another of the additional dielectric regions, and the substrate carrier is movable along a transport direction in order to transport the at least one substrate into or out off a PECVD system.

In the present invention, the dielectric region below each of the substrates provides an individual capacitive divider for each substrate, such as a silicon wafer. This results in the same plasma potential on top of each substrate, independently from the location of the respective substrate on the substrate carrier. Thus, the same deposited layer thickness and quality can be reached for each individual substrate.

According to the present invention, different heights of dielectric are formed below the substrates leading to different dielectric effects which compensate for non-uniformities of the reactor. For example, a compensation of the higher deposition rate in the center of the reactor can be reached.

The present invention uses a variation of the electric capacity below each substrate which reduces effects resulting i.e. from the non-continuity of the reactor, the standing wave effect or other influences that lead to non-uniformities of the plasma.

To govern the capacitive division between the grounded substrate carrier and the conductive or semi-conductive substrate, the substrate rests in the present invention on the dielectric region. That guarantees an electric de-coupling of the substrate carrier and the substrate to be treated. The dielectric region can be localized at selected points and/or lines or can cover the same area as the substrate.

In the present invention, the corrective measures to get a better homogeneity during plasma treatment are placed in particular in the substrate carrier plate. Therefore, the substrate treatment system of the present invention is able to react in a simple way on different process conditions or RF frequencies without opening the reactor.

The present invention is, for instance, applicable in parallel plate PECVD plasma deposition systems to grow more uniform layers on different substrates such as conductors, semiconductors, for example crystalline silicon wafers, or any kind of non-conductive materials . The present invention leads to nearly identical plasma condition in a whole large area PECVD reactor leading to nearly identical layer quality for each of the multiple substrates lying on the substrate carrier or on the entire surface of a large substrate. This makes it possible to develop large plasma reactors without increasing non-uniformity in the treatment of the substrates, such as a plasma-enhanced chemical vapour deposition on the substrates. Moreover, the present invention allows a better control of deposition homogeneity on top of individual substrates. In particular, edge effects on substrates can be better compensated by the present invention.

The substrate carrier of the substrate treatment system of the present invention can be adapted to different types of substrates, such as substrates of different material and/or of different thickness.

The present invention works independently from the kind of plasma source used in the substrate treatment system as long as the half of the excitation wavelength is longer than the diagonal of the electrically driven electrode. For instance, the invention can be applied to the use of linear VHF sources. The substrate treatment system of the present invention allows flexible adjustments of an existing parallel plate reactor to different process conditions such as pressure, gas flows and/or gas composition. In particular, an existing parallel plate reactor can be adapted to different radio frequencies.

In the present invention, the substrate carrier carries at least two of the substrates and comprises at least two of the dielectric regions being spaced and electrically disconnected from each other by a base material of the substrate carrier and being allocated to at least two of the substrates, respectively.

In a further embodiment of the present invention, the at least one dielectric region is formed as or in a cavity or a hole in the substrate carrier and/or the at least one additional dielectric region is formed as a cavity or in a cavity in the electrode.

In a further embodiment of the present invention, the at least one dielectric region is formed as or by at least one support structure protruding from a front surface of the substrate carrier and/or the at least one additional dielectric region is formed as or by at least one support structure protruding from a front surface of the electrode.

In this embodiment, the support structure can be constructed in such a way that a support structure comprising pins protruding from the front surface of the substrate carrier and/or from the front surface of the electrode is provided.

In a preferred example of the present invention, the support structure protruding from the front surface of the substrate carrier supports a metal plate carrying the substrate.

Favorably, in this embodiment, the support structure protruding from the front surface of the substrate carrier is at least partially of electrically non-conductive material.

In a favorable solution of the present invention, the at least one substrate is not in electrical contact with the front surface of the substrate carrier.

In another embodiment of the present invention, the at least one dielectric region and/or the at least one additional dielectric region is at least partially filled with or consists at least partially of air and/or another dielectric material.

The object is further solved by a PECVD process being performed by using a substrate treatment system of one of the present invention.

Preferred examples of the present invention are shown in the accompanying drawings in which
- Fig. 1: schematically shows a substrate treatment system according to an embodiment of the present invention in a side view;
- Fig. 2: schematically shows the substrate carrier of the substrate treatment system of Fig. 1 in a side view according to a first embodiment of the present invention;
- Fig. 3: schematically shows a variant of the substrate carrier of the substrate treatment system in a side view according to a second embodiment of the present invention;
- Fig. 4: schematically shows a further variant of the substrate carrier of the substrate treatment system in a side view according to a third embodiment of the present invention;
- Fig. 5: schematically shows another variant of the substrate carrier of the substrate treatment system in a side view according to a fourth embodiment of the present invention;
- Fig. 6: schematically shows another variant of the substrate carrier of the substrate treatment system in a side view according to a fifth embodiment of the present invention;
- Fig. 7: schematically shows a further variant of the substrate carrier of the substrate treatment system in a side view according to a sixth embodiment of the present invention;
- Fig. 8: schematically shows another example of the substrate carrier of the substrate treatment system in a side view according to a seventh embodiment of the present invention;
- Fig. 9: schematically shows a further example of the substrate carrier of the substrate treatment system in a side view according to an eighth embodiment of the present invention;
- Fig. 10: schematically shows another example of the substrate carrier of the substrate treatment system in a side view according to a ninth embodiment of the present invention;
- Fig. 11: schematically shows a further variant of the electrode and the substrate carrier of the substrate treatment system of Fig. 1 according to a tenth embodiment of the present invention;
- Fig. 12: schematically shows another variant of the electrode und the substrate carrier of the substrate treatment system of Fig. 1 according to an eleventh embodiment of the present invention;
- Fig. 13: schematically shows another variant of the electrode and the substrate carrier of the substrate treatment system of Fig. 1 according to a twelfth embodiment of the present invention;
- Fig. 14: schematically shows a further variant of the electrode and the substrate carrier of the substrate treatment system of Fig. 1 according to a thirteenth embodiment of the present invention; and
- Fig. 15: schematically shows a further variant of the electrode and the substrate carrier of the substrate treatment system of Fig. 1 according to a fourteenth embodiment of the present invention.

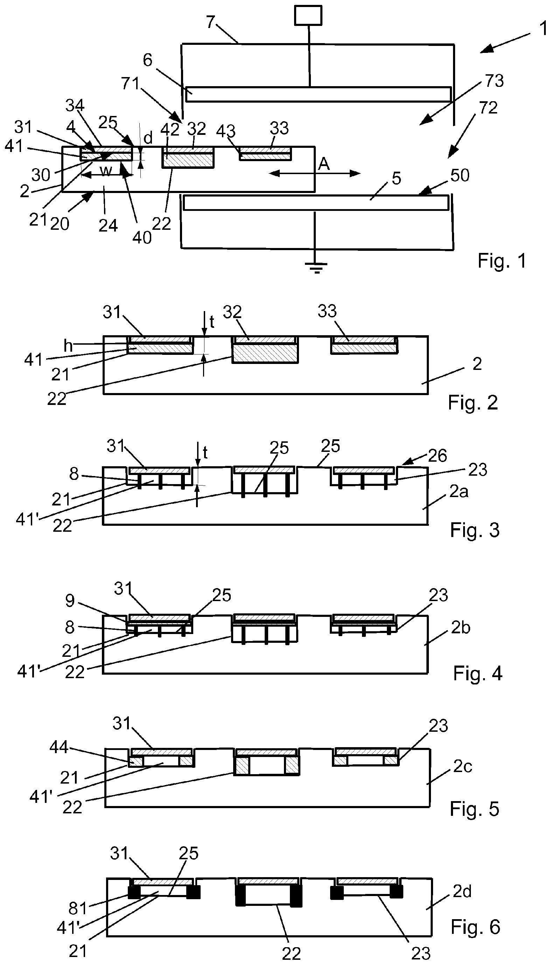

Fig. 1 schematically shows a substrate treatment system 1 according to an embodiment of the present invention in a side view. The substrate treatment system 1 comprises at least one substrate carrier 2 which is shown in an enhanced view in Fig. 2. The substrate carrier 2 carries in the example shown multiple plate-like substrates 31, 32, 33. The substrate carrier 2 comprises dielectric regions 41, 42, 43 below the substrates 31, 32, 33. Thus, a front side 4 of the respective dielectric region 41, 42, 43 is opposite to a back side 30 of the respective substrate 31, 32, 33. Each of the dielectric regions 41, 42, 43 is allocated to one of the substrates 31, 32, 33, respectively.

The dielectric regions 41, 42, 43 are spaced and electrically disconnected from each other by a base material 24 of the substrate carrier 2.

The substrate carrier 2 is movable along a transport direction A in order to transport the substrates 31, 32, 33 through a system entrance gate 71 in and through a system departure gate 72 out off a PECVD system 7 and/or vice versa. The PECVD system 7 comprises, in the example shown, a first electrically conductive electrode 5 which is below the substrate carrier 2 during its movement through the PECVD system 7. In other words, the first electrically conductive electrode 5 is provided on a back side 20 of the substrate carrier 2.

The PECVD system 7 further comprises in the example shown a second electrically conductive electrode 6 which is over the substrate carrier 2 during its movement through the PECVD system 7. The second electrically conductive electrode 6 can be a showerhead electrode which is connected with a gas input system of the substrate treatment system 1.

During a PECVD process, a plasma is formed in an area 73 between the electrically driven second electrically conductive electrode 6 and the substrates 31, 32, 33 on the substrate carrier 2.

In the example shown in Figs. 1 and 2, a distance d between the back side 30 of the substrates 31, 32, 33 and a back side 40 of the respective dielectric regions 41, 42, 43 varies from the dielectric regions 41 to the next dielectric region 42 and from said dielectric region 42 to the next dielectric region 43.

This is realized in the substrate carrier 2 by cavities 21, 22 or holes formed in the base material 24 of the substrate carrier 2. The cavities 21, 22 or holes have different depths t over the area of the substrate carrier 2. The cavities 21, 22 or holes are filled up to a certain height h with a dielectric material. The height h of the dielectric material inside each cavity 21, 22 is equal, but the thickness d of the dielectric material varies from cavity 21 to the next cavity 22 due to the different depths of the cavities 21, 22 or holes. In further non-shown embodiments of the present invention, the substrate carrier 2 can be constructed in such a way that a distance between the back side 30 of at least one of the substrates 31, 32, 33 and the back side 40 of at least one of the dielectric regions 41, 42, 43 varies over the width of the dielectric region(s) 41, 42, 43.

In other non-shown embodiments of the present invention, the substrate carrier 2 can also carry only one large substrate 31.

In the figures described in the following, same reference signs relate to same or comparable components of the present invention as described above with reference to Figs. 1 and 2. Therefore, the explanation of these components as made above can also be applied to the corresponding components of the other figures of the present application.

Fig. 3 schematically shows a substrate carrier 2a which can be used instead of the substrate carrier 2 in the substrate treatment system 1 of Fig. 1. In a front side 26 of the substrate carrier 2a, cavities 21, 22 or holes are formed. The cavities 21, 22 are filled with air or another gas. The cavities 21, 22, 23 have different depths t over the area of the substrate carrier 2a. The substrates 31, 32, 33 are hold in the cavities 21, 22, 23 by a support structure 8. The support structure 8 can be formed by pins, as in the example shown. The support structure 8 protruding from the front surface 25 of the substrate carrier 2a is at least partially of electrically non-conductive material. Inside the cavity 21, 22, 23 is air as dielectric material 41'.

The front surface 25 of the substrate carrier 2, 2a-k extends not only on the upper surface of the substrate carrier 2, 2a-k but also on the bottom of the cavities 21, 22, 23. The at least one substrate 31, 32, 33 is not in electrical contact with the front surface 25 of the substrate carrier 2, 2a-k.

Fig. 4 schematically shows a substrate carrier 2b in a side view which can also be used instead of the substrate carrier 2 or 2a in the substrate treatment system 1 of Fig. 1. As in the substrate carrier 2a, in a front side 26 of the substrate carrier 2b, cavities 21, 22, 23 are formed. The cavities 21, 22, 23 are filled with air or another gas. The substrates 31, 32, 33 are hold in the cavities 21, 22, 23 on a metal plate 9 which is hold by a support structure 8 that is not electrically conductive. The support structure 8 is formed by pins protruding from the front surface 25 of the substrate carrier 2b in the bottom of the cavities 21, 22, 23. Inside the cavity 21, 22, 23 is air or another gas as dielectric material 41'.

Fig. 5 shows a side view of a substrate carrier 2c which can also be used instead of the substrate carrier 2, 2a or 2b in the substrate treatment system 1 of Fig. 1. As in the substrate carriers 2a and 2b, in a front side 26 of the substrate carrier 2c cavities 21, 22, 23 are formed. The cavities 21, 22, 23 are filled with air or another gas. The substrates 31, 32, 33 are hold in the cavities 21, 22, 23 by areas of dielectric material 44 formed at the edges of the front surface 25 of the substrate carrier 2c on the bottom of the cavities 21, 22, 23. Inside the cavity 21, 22, 23 is air or another gas as dielectric material 41'.

Fig. 6 shows a side view of a substrate carrier 2d which can also be used instead of the substrate carrier 2, 2a, 2b or 2c in the substrate treatment system 1 of Fig. 1. As in the substrate carriers 2a, 2b and 2c, in a front side 26 of the substrate carrier 2c cavities 21, 22, 23 or holes are formed. The cavities 21, 22, 23 are filled with air or another gas. The substrates 31, 32, 33 are hold in the cavities 21, 22, 23 by support means 81 formed at the edges of the cavities 21, 22, 23 or holes and protruding from the front surface 25 on the bottom of the cavities 21, 22, 23 of the substrate carrier 2d.

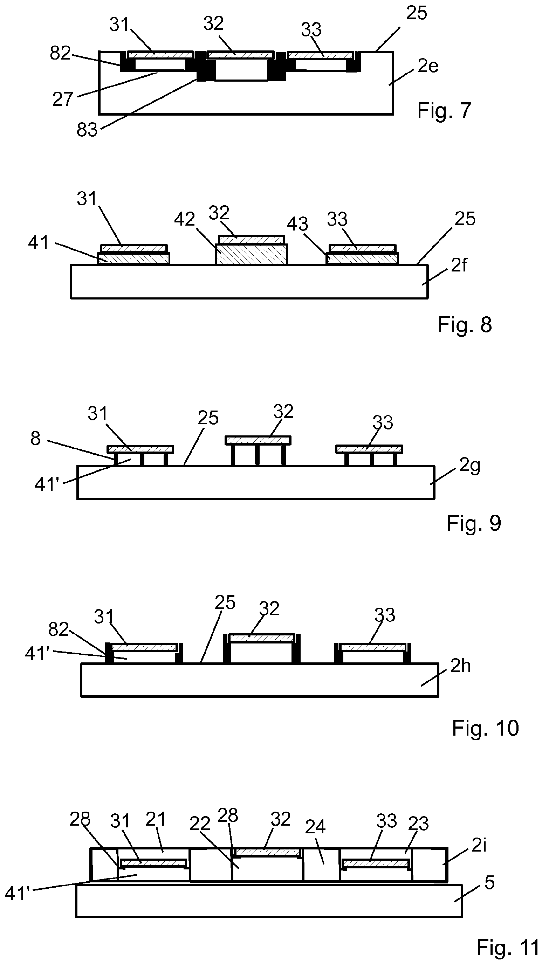

In another variant of a substrate carrier 2e shown schematically in Fig. 7, all of the substrates 31, 32, 33 are provided in one cavity 27 having different depths over the area of the substrate carrier 2e, wherein the substrates 31, 32, 33 are hold in the cavity 27 and separated from each other by a support structure having support means provided on the bottom of the cavity 27, either in form of an angle bracket 82 at the edge of the cavity 27 or in form of a multilateral supporter 83 with different lengths of its supporting legs between the substrates 31, 32, 33.

Fig. 8 shows a side view of a substrate carrier 2f which can also be used instead of the substrate carrier 2, 2a, 2b, 2c, 2d or 2e in the substrate treatment system 1 of Fig. 1. Dielectric regions 41, 42, 43 with different thicknesses are formed on the surface 25 of the substrate carrier 2f. The substrates 31, 32, 33 are located on these dielectric regions 41, 42, 43 at different heights.

In the example of the substrate carrier 2g of Fig. 9, the substrates 31, 32, 33 are located on support structures 8 in the form of pins with different heights from substrate to substrate. The areas between the front surface 25 of the substrate carrier 2g and the substrates 31, 32, 33 are of air or another gas and form a dielectric region 41'.

Fig. 10 shows a side view of another substrate carrier 2h which can also be used instead of the substrate carrier 2, 2a-g in the substrate treatment system 1 of Fig. 1. The substrates 31, 32, 33 lie here on support structures being in the form of angle brackets 82 and protruding from the front surface 25.

Fig. 11 schematically shows a further variant of the electrode 5 and a substrate carrier 2i which can be used instead of the substrate carrier 2, 2a-2h in the substrate treatment system 1 of Fig. 1. The substrate carrier 2i comprises holes 21, 22, 23 going through the base material 24 of the substrate carrier 2i. At the inside of these holes 21, 22, 23 holders 28 are provided in different heights to hold the substrates 31, 32, 33 thereon inside the holes 21, 22, 23. Thus, the substrates 31, 32, 33 are provided in such a way inside the holes 21, 22, 23 that the respective surface 34 of the substrates 31, 32, 33 is on a different level. The space between the substrates 31, 32, 33 and the electrode 5 is a dielectric region 41' which varies.

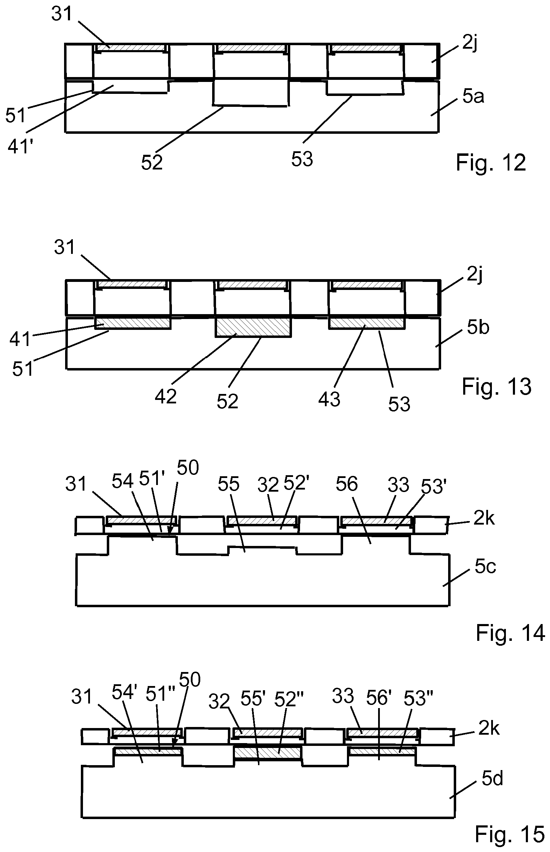

Fig. 12 schematically shows another variant of an electrode 5a und a substrate carrier 2j which can be used instead of the electrode 5 and the substrate carrier 2, 2a-2i in the substrate treatment system 1 of Fig. 1. The electrode 5a comprises cavities 51, 52, 53 which are filled with air or another gas. The substrate carrier 2j comprises holes 21, 22, 23 going through the base material 24 of the substrate carrier 2j. At the inside of these holes 21, 22, 23 holders 28 are provided at the same height to hold the substrates 31, 32, 33 thereon inside the holes 21, 22, 23. The substrates 31, 32, 33 are provided in such a way inside the holes 21, 22, 23 that the respective surface 34 of the substrates 31, 32, 33 is flush with the adjacent area of the front surface 25 of the substrate carrier 2i. During a PECVD process, the holes 21, 22, 23 of the substrate carrier 2j are on top of the holes 51, 52, 53 of the electrode 5. The space between the substrates 31, 32, 33 and the bottom of the holes 51, 52, 53 forms a dielectric region 41' which varies due to the different depths of the holes 51, 52, 53.

Fig. 13 schematically shows yet another variant of an electrode 5b und the substrate carrier 2j which can be used instead of the electrode 5, 5a and the substrate carrier 2, 2a-2i in the substrate treatment system 1 of Fig. 1. The electrode 5b comprises cavities 51, 52, 53 which are filled with a dielectric material 41, 42, 43. The substrate carrier 2j comprises holes 21, 22, 23 going through the base material 24 of the substrate carrier 2j.

At the inside of these holes 21, 22, 23 holders 28 are provided at the same height to hold the substrates 31, 32, 33 thereon inside the holes 21, 22, 23. The substrates 31, 32, 33 are provided in such a way inside the holes 21, 22, 23 that the respective surface 34 of the substrates 31, 32, 33 is flush with the adjacent area of the front surface 25 of the substrate carrier 2i. During a PECVD process, the holes 21, 22, 23 of the substrate carrier 2j are on top of the holes 51, 52, 53 of the electrode 5b. The space below the substrates 31, 32, 33 and the dielectric material 41, 42, 43 form a dielectric which varies due to the different depths of the filled holes 51, 52, 53.

Fig. 14 schematically shows a further variant of an electrode 5c and the substrate carrier 2k which can be used instead of the electrode 5, 5a or 5b and the substrate carrier 2, 2a-2j in the substrate treatment system 1 of Fig. 1. The substrate carrier 2k is similarly constructed as the substrate carrier 2j described above. The electrode 5c comprises on its front surface 50 regions 54, 55, 56 of different heights. During the PECVD process, the regions 54, 55, 56 of different heights are below the substrates 31, 32, 33. Thus, the dielectric formed between the respective substrate 31, 32, 33 and the electrode 5c is composed of the free space below each substrate 31, 32, 33 which varies due to the different heights of the front surface 50 of the electrode 5c.

Fig. 15 schematically shows a further variant of an electrode 5d and the substrate carrier 2k which can be used instead of the electrode 5, 5a, 5b or 5c and the substrate carrier 2, 2a-2j in the substrate treatment system 1 of Fig. 1. The substrate carrier 2k is similarly constructed as the substrate carrier 2j described above. The electrode 5d comprises on its front surface 50 heightened regions 54', 55', 56' of different heights. On the heightened regions 54', 55', 56', dielectric regions 51", 52", 53" are provided in such a way that the end thickness of the heightened region + dielectric region is about the same over the area of the electrode 5d. Thus, the thickness of the dielectric regions 51", 52", 53" varies over the area of the electrode 5d. During a PECVD process, the dielectric regions 51", 52", 53" are below the substrates 31, 32, 33. Thus, the dielectric formed between the respective substrate 31, 32, 33 and the electrode 5d varies due to the different thicknesses of the dielectric regions 51", 52", 53" of the electrode 5d.

In other, non-shown examples of the substrate treatment system 1 of the present invention, the first electrically conductive electrode 5 can be included in or is part of or is formed by the moveable substrate carrier 2, 2a-h. In these cases, the substrate carrier 2, 2a-2h does not only carry the substrates 31, 32, 33 and the respective dielectric regions, but also plays the role of the first electrically conductive electrode 5 as counter electrode to the second electrically conductive electrode 6.

In further embodiments of the substrate treatment system 1 of the present invention, the substrate carrier 2, 2a-k and/or the first electrically conductive electrode 5, 5a, 5b, 5c or 5d can serve as RF electrode, whereas the second electrically conductive electrode 6 is the grounded electrode.

The invention is defined by the appended claims.

## Claims

1. Substrate treatment system (1) with at least one substrate carrier (2, 2a-k) carrying at least one plate-like substrate (31, 32, 33) and comprising at least one dielectric region (41, 42, 43, 44, 41'), wherein a front side (4) of the dielectric region (41, 42, 43, 44, 41') is opposite to a back side (30) of the substrate (31, 32, 33), and with an electrically conductive electrode (5) provided on the back side (20) of the substrate carrier (2, 2a-k) or being formed by the substrate carrier (2, 2a-k),
**characterized in that**
the substrate carrier (2, 2a-k) carries at least two of the substrates (31, 32, 33) and comprises at least two of the dielectric regions (41, 42, 43, 44, 41') being spaced and electrically disconnected from each other by a base material (24) of the substrate carrier (2, 2a-k) and being allocated to at least two of the substrates (31, 32, 33), respectively, wherein the substrate carrier (2, 2a-k) is movable along a transport direction (A) in order to transport the at least two substrates (31, 32, 33) into or out off a PECVD system (7), and wherein
- a distance (d) between the respective back side (30) of each of the at least two substrates (31, 32, 33) and a respective back side (40) of each of the at least two dielectric regions (41, 42, 43, 44, 41') varies over the width (w) of the respective dielectric region (41, 42, 43, 44, 41') and/or varies from one of the dielectric regions (41) to another of the dielectric regions (42), and/or
the electrically conductive electrode (5) comprises at least two additional dielectric regions (51, 52, 53) being allocated to the at least two dielectric regions (41, 42, 43, 44, 41'), respectively, and a distance (dₐ) between the respective back side (30) of each of the at least two substrates (31, 32, 33) and a respective back side (50) of each of the at least two additional dielectric regions (51, 52, 53) varies over the width (wₐ) of the respective additional dielectric region (51, 52, 53) and/or varies from one of the additional dielectric (51) regions to another of the additional dielectric regions (52).

2. Substrate carrier system of claim 1, **characterized in that** each of the at least two dielectric regions (41, 42, 43, 41') is formed as or in a cavity (21, 22) or a hole in the substrate carrier (2, 2a-k) and/or each of the at least two additional dielectric regions (51, 52, 53) is formed as a cavity or in a cavity in the electrode (5).

3. Substrate carrier system of claim 1, **characterized in that** each of the at least two dielectric regions (44) is formed as or by at least one support structure protruding from a front surface (25) of the substrate carrier (2, 2a-k) and/or each of the at least two additional dielectric regions (54) is formed as or by at least one support structure protruding from a front surface (50) of the electrode (5).

4. Substrate carrier system of at least one of the preceding claims, **characterized in that** a support structure comprising pins (8) protruding from the front surface (25) of the substrate carrier (2, 2a-k) and/or from the front surface (50) of the electrode (5) is provided.

5. Substrate carrier system of at least one of the preceding claims, **characterized in that** a support structure (44, 8, 81, 82, 83) protruding from the front surface (25) of the substrate carrier (2, 2a-k) supports a metal plate (9) carrying the substrate (34).

6. Substrate carrier system of one of the claims 4 to 5, **characterized in that,** the at least two substrates (31, 32, 33) are not in electrical contact with the front surface (25) of the substrate carrier (2, 2a-k).

7. Substrate carrier system of claim 6, **characterized in that** the support structure (44, 8, 81, 82, 83) protruding from the front surface (25) of the substrate carrier (2, 2a-k) is at least partially of electrically non-conductive material.

8. Substrate carrier system of one of the preceding claims, **characterized in that,** the at least two dielectric regions (41, 42, 43, 44, 41') and/or the at least two additional dielectric regions (51, 52, 53) are at least partially filled with or consist at least partially of air and/or another dielectric material.

9. PECVD process being performed by using a substrate treatment system (1) of one of the preceding claims.

## Patentansprüche

1. Substratbehandlungssystem (1) mit wenigstens einem Substratträger (2, 2a-k), der wenigstens ein plattenartiges Substrat (31, 32, 33) aufnimmt und wenigstens einen dielektrischen Bereich (41, 42, 43, 44, 41') umfasst, wobei eine Vorderseite (4) des dielektrischen Bereichs (41, 42, 43, 44, 41') einer Rückseite (30) des Substrats (31, 32, 33) gegenüberliegt, und mit einer elektrisch leitfähigen Elektrode (5), die auf der Rückseite (20) des Substratträgers (2, 2a-k) vorgesehen ist oder durch den Substratträger (2, 2a-k) ausgebildet ist,
**dadurch gekennzeichnet, dass**
der Substratträger (2, 2a-k) wenigstens zwei der Substrate (31, 32, 33) aufnimmt und wenigstens zwei der dielektrischen Bereiche (41, 42, 43, 44, 41'), die durch ein Grundmaterial (24) des Substratträgers (2, 2a-k) voneinander beabstandet und elektrisch getrennt sind und jeweils wenigstens zwei der Substrate (31, 32, 33) zugeordnet sind, aufweist, wobei der Substratträger (2, 2-k) entlang einer Transportrichtung (A) bewegbar ist, um die wenigstens zwei Substrate (31, 32, 33) in ein PECVD-System (7) hinein oder daraus heraus zu transportieren, und wobei ein Abstand (d) zwischen der jeweiligen Rückseite (30) jedes der wenigstens zwei Substrate (31, 32, 33) und einer jeweiligen Rückseite (40) jedes der wenigstens zwei dielektrischen Bereiche (41, 42, 43, 44, 41 ') über die Breite (w) des jeweiligen dielektrischen Bereichs (41, 42, 43, 44, 41') variiert und/oder von einem der dielektrischen Bereiche (41) zu einem anderen der dielektrischen Bereiche (42) variiert,
und/oder
die elektrisch leitfähige Elektrode (5) wenigstens zwei zusätzliche dielektrische Bereiche (51, 52, 53), die jeweils den wenigstens zwei dielektrischen Bereichen (41, 42, 43, 44, 41') zugeordnet sind, aufweist, und ein Abstand (dₐ) zwischen der jeweiligen Rückseite (30) jedes der wenigstens zwei Substrate (31, 32, 33) und einer jeweiligen Rückseite (50) jedes der wenigstens zwei zusätzlichen dielektrischen Bereiche (51, 52, 53) über die Breite (wₐ) des jeweiligen zusätzlichen dielektrischen Bereichs (51, 52, 53) variiert und/oder von einem der zusätzlichen dielektrischen Bereiche (51) zu einem anderen der zusätzlichen dielektrischen Bereiche (52) variiert.

2. Substratträgersystem nach Anspruch 1, **dadurch gekennzeichnet, dass** jeder der wenigstens zwei dielektrischen Bereiche (41, 42, 43, 41') als oder in einem Hohlraum (21, 22) oder Loch in dem Substratträger (2, 2a-k) ausgebildet ist und/oder jeder der wenigstens zwei zusätzlichen dielektrischen Bereiche (51, 52, 53) als ein Hohlraum oder in einem Hohlraum in der Elektrode (5) ausgebildet ist.

3. Substratträgersystem nach Anspruch 1, **dadurch gekennzeichnet, dass** jeder der wenigstens zwei dielektrischen Bereiche (44) als oder durch wenigstens eine aus einer vorderen Oberfläche (25) des Substratträgers (2, 2a-k) herausragenden Trägerstruktur ausgebildet ist, und/oder jeder der wenigstens zwei zusätzlichen dielektrischen Bereiche (54) als oder durch wenigstens eine aus einer vorderen Oberfläche (50) der Elektrode (5) herausragenden Trägerstruktur ausgebildet ist.

4. Substratträgersystem nach wenigstens einem der vorhergehenden Ansprüche, **dadurch gekennzeichnet, dass** eine Trägerstruktur mit aus der vorderen Oberfläche (25) des Substratträgers (2, 2a-k) und/oder aus der vorderen Oberfläche (50) der Elektrode (5) herausragenden Stiften (8) vorgesehen ist.

5. Substratträgersystem nach wenigstens einem der vorhergehenden Ansprüche, **dadurch gekennzeichnet, dass** auf einer aus der vorderen Oberfläche (25) des Substratträgers (2, 2a-k) herausragenden Trägerstruktur (44, 8, 81, 82, 83) eine das Substrat (34) aufnehmende Metallplatte (9) gelagert ist.

6. Substratträgersystem nach einem der Ansprüche 4 oder 5, **dadurch gekennzeichnet, dass** die wenigstens zwei Substrate (31, 32, 33) nicht in elektrischem Kontakt mit der vorderen Oberfläche (25) des Substratträgers (2, 2a-k) stehen.

7. Substratträgersystem nach Anspruch 6, **dadurch gekennzeichnet, dass** die aus der vorderen Oberfläche (25) des Substratträgers (2, 2a-k) herausragende Trägerstruktur (44, 8, 81, 82, 83) wenigstens teilweise aus elektrisch nicht leitfähigem Material ist.

8. Substratträgersystem nach einem der vorhergehenden Ansprüche, **dadurch gekennzeichnet, dass** die wenigstens zwei dielektrischen Bereiche (41, 42, 43, 44, 41') und/oder die wenigstens zwei zusätzlichen dielektrischen Bereiche (51, 52, 53) wenigstens teilweise mit Luft und/oder einem anderen dielektrischen Material gefüllt sind oder wenigstens teilweise daraus bestehen.

9. PECVD-Vorgang, der durch Verwenden eines Substratbehandlungssystems (1) nach einem der vorhergehenden Ansprüche durchgeführt wird.

## Revendications

1. Système de traitement de substrat (1) présentant au moins un porteur de substrat (2, 2a-k) portant au moins un substrat en forme de plaque (31, 32, 33) et comprenant au moins une région diélectrique (41, 42, 43, 44, 41'), un côté avant (4) de la région diélectrique (41, 42, 43, 44, 41') étant opposé à un côté arrière (30) du substrat (31, 32, 33), et présentant une électrode électriquement conductrice (5) prévue sur le côté arrière (20) du porteur de substrat (2, 2a-k) ou étant formée par le porteur de substrat (2, 2a-k),
**caractérisé en ce que** le porteur de substrat (2, 2a-k) porte au moins deux des substrats (31, 32, 33) et comprend au moins deux des régions diélectriques (41, 42, 43, 44, 41') étant espacées et déconnectées électriquement l'une de l'autre par un matériau de base (24) du porteur de substrat (2, 2a-k) et étant attribuées à au moins deux des substrats (31, 32, 33), respectivement, le porteur de substrat (2, 2a-k) étant mobile le long d'une direction de transport (A) afin de transporter les au moins deux substrats (31, 32, 33) dans ou hors d'un système PECVD (7), et
une distance (d) entre le côté arrière (30) respectif de chacun des au moins deux substrats (31, 32, 33) et un côté arrière (40) respectif de chacune des au moins deux régions diélectriques (41, 42, 43, 44, 41') variant sur la largeur (w) de la région diélectrique (41, 42, 43, 44, 41') respective et/ou variant d'une des régions diélectriques (41) à une autre des régions diélectriques (42),
et/ou
l'électrode électriquement conductrice (5) comprenant au moins deux régions diélectriques supplémentaires (51, 52, 53) étant attribuées aux au moins deux régions diélectriques (41, 42, 43, 44, 41'), respectivement, et une distance (dₐ) variant entre le côté arrière (30) respectif de chacun des au moins deux substrats (31, 32, 33) et un côté arrière (50) respectif de chacune des au moins deux régions diélectriques supplémentaires (51, 52, 53) variant sur la largeur (wₐ) de la région diélectrique supplémentaire (51, 52, 53) respective et/ou variant d'une des régions diélectriques supplémentaires (51) à une autre des régions diélectriques supplémentaires (52).

2. Système de porteur de substrat selon la revendication 1, **caractérisé en ce que** chacune des au moins deux régions diélectriques (41, 42, 43, 41') est formée en tant que ou dans une cavité (21, 22) ou un trou dans le porteur de substrat (2, 2a-k) et/ou chacune des au moins deux régions diélectriques supplémentaires (51, 52, 53) est formée en tant que cavité ou dans une cavité dans l'électrode (5).

3. Système de porteur de substrat selon la revendication 1, **caractérisé en ce que** chacune des au moins deux régions diélectriques (44) est formée en tant que ou par au moins une structure de support faisant saillie depuis une surface avant (25) du porteur de substrat (2, 2a-k) et/ou chacune des au moins deux régions diélectriques supplémentaires (54) est formée en tant que ou par au moins une structure de support faisant saillie depuis une surface avant (50) de l'électrode (5).

4. Système de porteur de substrat selon au moins l'une des revendications précédentes, **caractérisé en ce qu'une** structure de support comprenant des goupilles (8) faisant saillie depuis la surface avant (25) du porteur de substrat (2, 2a-k) et/ou depuis la surface avant (50) de l'électrode (5) est prévue.

5. Système de porteur de substrat selon au moins l'une des revendications précédentes, **caractérisé en ce qu'**une structure de support (44, 8, 81, 82, 83) faisant saillie depuis la surface avant (25) du porteur de substrat (2, 2a-k) soutient une plaque métallique (9) portant le substrat (34).

6. Système de porteur de substrat selon l'une des revendications 4 à 5, **caractérisé en ce que** les au moins deux substrats (31, 32, 33) ne sont pas en contact électrique avec la surface avant (25) du porteur de substrat (2, 2a-k).

7. Système de porteur de substrat selon la revendication 6, **caractérisé en ce que** la structure de support (44, 8, 81, 82, 83) faisant saillie depuis la surface avant (25) du porteur de substrat (2, 2a-k) se compose au moins partiellement d'un matériau électriquement non conducteur.

8. Système de porteur de substrat selon l'une des revendications précédentes, **caractérisé en ce que** les au moins deux régions diélectriques (41, 42, 43, 44, 41') et/ou les au moins deux régions diélectriques supplémentaires (51, 52, 53) sont au moins partiellement remplies ou se composent au moins partiellement d'air et/ou d'un autre matériau diélectrique.

9. Procédé de PECVD effectué à l'aide d'un système de traitement de substrat (1) selon l'une des revendications précédentes.
